# FASCICULE DE BREVET EUROPEEN

(11) **EP 2 577 395 B1**
(45) Date de publication et mention de la délivrance du brevet: **28.08.2019**
(21) Numéro de dépôt: 11721525.1
(22) Date de dépôt: 25.05.2011
(51) Int. Cl.: G03F 7/00, H01L 21/033, H01L 21/768, H01L 21/311, B81C 1/00

(54) **PROCEDE DE LITHOGRAPHIE A DEDOUBLEMENT DE PAS**
LITHOGRAFISCHES VERFAHREN FÜR PITCHVERDOPPLUNG
LITHOGRAPHIC PITCH DOUBLING PROCESS

(30) Priorité: 01.06.2010 FR 1002306
(43) Date de publication de la demande: 10.04.2013
(73) Titulaire: Commissariat à l'Énergie Atomique et aux Énergies Alternatives, 75015 Paris (FR)
(72) Inventeur: PAIN, Laurent, F-38500 St Nicolas De Macherin (FR); BELLEDENT, Jérôme, 38920 Crolles (FR); BARNOLA, Sébastien, F-38190 Villard-Bonnot (FR)
(74) Mandataire: Bréda, Jean-Marc
(86) Numéro de dépôt international: PCT/EP2011/058598
(87) Numéro de publication internationale: WO 2011/151243

(56) Documents cités:
- EP-A1- 1 772 773
- EP-A1- 1 804 282
- EP-A2- 1 912 257
- EP-A2- 1 998 363
- GB-A- 2 289 948
- US-A- 5 328 810
- US-A1- 2003 127 426
- US-A1- 2005 170 670
- US-A1- 2006 046 484
- US-A1- 2006 281 266
- US-A1- 2007 224 819
- US-A1- 2009 202 952
- US-B1- 6 632 741
- US-B1- 6 667 237

## Description

L'invention concerne la lithographie pour la gravure de motifs très denses sur un substrat, par exemple pour la réalisation de circuits intégrés de microélectronique.

Par motifs denses, on entend des motifs dont certains éléments sont de très petite largeur et séparés par des intervalles de très petite largeur. Avec la photolithographie, on expose une couche sensible, par exemple à travers un masque, à un faisceau par exemple ultraviolet, typiquement à une longueur d'onde de 193 nanomètres. La densité des motifs, c'est-à-dire la résolution qu'on peut atteindre dans la gravure du motif, est liée à plusieurs paramètres mais elle dépend d'abord de la longueur d'onde utilisée ; plus elle est courte plus la densité est grande. On peut augmenter la densité des motifs en utilisant l'extrême ultraviolet (notamment à 13,5 nanomètres) ; on peut l'augmenter aussi en utilisant une exposition par un faisceau électronique de diamètre très étroit, mais le processus de gravure est beaucoup plus lent car l'écriture d'un motif se fait point par point et non à travers un masque global définissant les motifs ; d'autre part, les faisceaux électroniques étroits peuvent engendrer des phénomènes de dispersion et rétrodiffusion d'électrons nuisant à la résolution.

Dans le domaine des mémoires, on a déjà proposé, pour augmenter la densité possible des lignes nécessaires pour réaliser ces mémoires, de réaliser les étapes suivantes :
- formation d'une couche sacrificielle sur un substrat,
- gravure de la couche sacrificielle selon des premières bandes,
- formation d'espaceurs le long de tous les bords des éléments de la couche sacrificielle ainsi gravée ;
- enlèvement de la couche sacrificielle pour ne laisser subsister que les espaceurs formant les lignes denses recherchées.

Ce procédé est parfois appelé lithographie à multiplication de pas car il aboutit à une distance entre lignes plus petite (pratiquement deux fois plus petite) que ce que permet une lithographie directe.

Le document EP 1804282 divulgue un procédé de lithographie pour graver un motif de densité élevée à partir d'une combinaison de plusieurs motifs partiels moins denses, comprenant la lithographie de deux couches. Néanmoins la seconde lithographie est contraignante car il faut que les couches issues des deux lithographies soient alignées.

L'invention vise à proposer un nouveau procédé pour réaliser des motifs 2D permettant d'augmenter la densité des motifs gravés en réalisant un motif dense à partir de la combinaison de plusieurs motifs partiels moins denses qui s'interpénètrent mutuellement.

Selon l'invention, on combine un motif partiel défini par une lithographie à multiplication de pas avec un motif défini par une lithographie directe, postérieure à la lithographie à multiplication de pas, la lithographie directe étant faite de manière à bénéficier, au moins dans une direction, de la résolution permise par la lithographie à multiplication de pas.

Dans ce qui suit, on considère que la lithographie à multiplication de pas comprend la formation d'espaceurs selon des lignes parallèles, et que la multiplication de pas, c'est-à-dire l'augmentation de résolution est donc obtenue dans une direction transversale à ces lignes parallèles. On va donc considérer dans la définition qui suit qu'on cherche à former par lithographie à multiplication de pas un motif d'au moins quatre lignes d'espaceurs (deux lignes centrales adjacentes, et deux lignes extérieures d'espaceurs qui encadrent les lignes centrales adjacentes). A ce motif défini par les espaceurs on associe un motif défini par lithographie directe, c'est-à-dire sans multiplication de pas qui aboutit à une résolution dans le sens transversal identique à celle que permet la lithographie à multiplication de pas.

Plus précisément, le procédé de lithographie selon l'invention comprend la formation d'une couche sacrificielle sur un substrat et une gravure de la couche sacrificielle selon un premier motif partiel comprenant des lignes parallèles, puis la formation d'espaceurs sur les bords des éléments de la couche sacrificielle ainsi gravée, puis l'enlèvement de la couche sacrificielle pour ne laisser subsister que les espaceurs, ceux-ci définissant un deuxième motif partiel d'au moins quatre lignes parallèles comprenant deux lignes centrales adjacentes et deux lignes extérieures, caractérisé en ce qu'on effectue ensuite le dépôt entre les espaceurs d'une couche complémentaire d'un matériau différent de celui des espaceurs sur une épaisseur inférieure ou égale à la hauteur des espaceurs, et on grave localement cette couche complémentaire selon un troisième motif partiel pour définir sur le substrat un motif final résultant de la combinaison des deuxième et troisième motifs partiels, et caractérisé en ce que le troisième motif partiel comprend au moins une zone qui s'étend dans une direction perpendiculaire aux lignes d'espaceurs, entre les deux lignes centrales, et qui s'arrête sur ces lignes sans déborder dans cette direction au-delà des lignes centrales adjacentes.

Le troisième motif est donc défini d'un côté par lithographie directe, et de l'autre par deux espaceurs adjacents définis par lithographie à multiplication de pas, mais le troisième motif, bien que défini par lithographie directe a dans la direction transversale une dimension qui correspond à la finesse permise par la lithographie à multiplication de pas.

Le troisième motif partiel peut être un motif de zone recouverte par la couche complémentaire ou au contraire un motif de zone dépourvue de couche complémentaire.

Pour réaliser ces motifs très petits, seules deux étapes de lithographie sont nécessaires.

Le fait que la couche complémentaire déposée entre les espaceurs soit déposée sur une épaisseur inférieure ou égale à la hauteur des espaceurs permet un effet d'autoalignement dans une direction de première lithographie (correspondant à la gravure de la couche sacrificielle) et de la seconde lithographie (correspondant à l'étape d'élimination locale de la couche déposée entre les espaceurs), relâchant ainsi les contraintes sur cette deuxième lithographie.

Avantageusement la couche complémentaire déposée entre les espaceurs, qui définit le troisième motif partiel, est en un matériau sensible à un rayonnement photonique ou électronique ou ionique, auquel cas, l'étape de retrait local peut se faire par exposition locale au rayonnement auquel la couche est sensible.

En variante, on dépose sur les espaceurs et la couche complémentaire déposée entre les espaceurs une couche en un matériau sensible à un rayonnement photonique ou électronique ou ionique que l'on vient lithographier pour générer des ouvertures qui vont servir pour la gravure sélective de la couche complémentaire située entre les espaceurs.

Avantageusement, on prévoit que le troisième motif partiel est défini par l'exposition à un faisceau électronique d'une couche sensible à ce faisceau, l'épaisseur de cette couche sensible étant inférieure ou égale à la hauteur des espaceurs, de sorte que la couche ne déborde pas sur les espaceurs. En effet, dans le cas d'une photolithographie classique, le développement de la couche photosensible recouvrant le motif d'espaceurs n'est pas facile pour les niveaux de résolution recherchée, en particulier du fait que la couche photosensible vient au-dessus des espaceurs et empêche une gravure à très haute résolution de la partie de couche située entre les espaceurs. Cette imprécision de gravure résulte notamment de l'existence de différences entre l'indice optique de la couche photosensible et celui des espaceurs et du fait que les dimensions des motifs à imprimer (entre les espaceurs) sont inférieures à la longueur d'onde : la lumière ne peut donc pas se propager facilement à l'intérieur du motif.

Le motif final peut être utilisé de la manière suivante : le substrat est creusé selon un motif final qui est celui des régions dépourvues d'espaceurs et de la couche complémentaire de matériau déposée entre les espaceurs (qui peut être une couche sensible à un rayonnement) ; les régions creusées peuvent être remplies par un matériau affleurant à la surface du substrat sans déborder des régions creusées (procédé de type damascène) ; le creusement du substrat peut être fait à travers un masque minéral ou masque dur, le motif final dense servant à la gravure de ce masque dur préalablement au creusement du substrat.

Si le substrat est en matériau isolant (par exemple un matériau diélectrique à faible constante diélectrique déposé sur une tranche de silicium) les régions creusées dans le substrat peuvent être remplies d'un matériau électriquement conducteur (cuivre notamment) pour former un réseau dense de conducteurs.

On exposera plus loin comment on peut utiliser ce procédé pour réaliser non seulement un réseau de conducteurs, mais en même temps des vias conducteurs entre deux réseaux de conducteurs qui se croisent.

D'autres caractéristiques et avantages de l'invention apparaîtront à la lecture de la description détaillée qui suit et qui est faite en référence aux dessins annexés dans lesquels :
- la figure 1 représente un exemple schématique de motif dense qu'on souhaite réaliser dans un substrat ;
- la figure 2 représente respectivement un premier motif partiel (2A), un deuxième motif partiel (2B) qui se déduit du premier, et un troisième motif partiel (2C) complétant le deuxième ;
- la figure 3 représente la combinaison du deuxième et du troisième motifs partiels, qui permettent d'établir le motif final dense de la figure 1 ;
- la figure 4 (4A à 4E) représente les étapes de réalisation du premier et du deuxième motifs partiels ;
- la figure 5 et la figure 6 représentent deux étapes qui suivent celles de la figure 4, dans un premier mode de réalisation ;
- les figures 7 à 9 représentent les phases de procédé exécutées à la suite des étapes de la figure 4, dans un deuxième mode de réalisation ;
- les figures 10 à 12 représentent un exemple d'utilisation du motif dense obtenu à la figure 9 pour réaliser un réseau de conducteurs dans un substrat ;
- la figure 13 représente en vue de dessus une application avec deux réseaux de conducteurs qui se croisent et des vias de contact entre les deux réseaux ;
- les figures 14 à 27 représentent une succession d'étapes pour la réalisation d'un réseau de conducteurs superposé à un autre réseau avec des vias entre les deux, en utilisant le procédé selon l'invention.

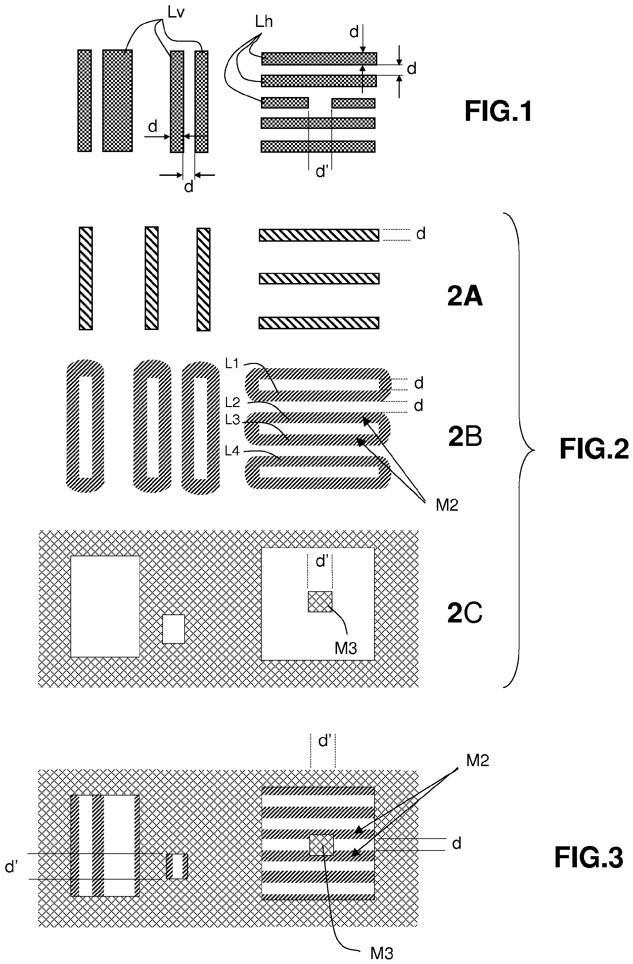

Sur la figure 1 on a représenté schématiquement en vue de dessus un exemple de motif dense qu'on veut réaliser avec le procédé selon l'invention. Le motif comprend des rangées rapprochées verticales Lv, et des lignes horizontales Lh ; une des lignes horizontales Lh est interrompue localement. Pour simplifier l'exemple, la largeur des lignes et leur espacement sont identiques et égaux à une distance d, aussi bien dans le sens vertical que dans le sens horizontal, de sorte qu'on peut dire que le pas d'espacement des lignes est 2d dans les deux sens ; la largeur de l'interruption de ligne horizontale s'étend sur une distance d' dans le sens de la longueur des lignes. La distance d'est une distance qui peut être obtenue par une opération de lithographie directe. Mais la distance d est très petite (environ 20 à 30 nanomètres) et les lignes sont très denses (le pas du réseau est typiquement inférieur à 75 nm, voire 60 nm) : cette résolution ne peut être obtenue par photolithographie simple de l'ensemble du motif ; elle peut cependant être obtenue par lithographie à multiplication de pas. On réalise donc le motif en combinant au moins deux motifs dans lesquels l'espacement des éléments du motif (ici les éléments sont des tronçons de lignes) est au moins deux fois moins dense.

La figure 2 représente trois motifs partiels moins denses, dont la combinaison va servir à réaliser l'ensemble du motif de la figure 1.

La figure 2A représente le premier motif partiel ; il sert à établir par multiplication de pas le deuxième motif partiel de la figure 2B ; il comprend ici trois lignes d'un matériau sacrificiel qui est éliminé ensuite ; l'espacement entre les lignes est supérieur à la largeur des lignes.

La figure 2B est un deuxième motif partiel, qui se déduit directement du premier motif de la manière suivante : les éléments du premier motif sont individuellement complètement entourés par un espaceur continu, puis ces éléments du premier motif sont éliminés. Le deuxième motif partiel est maintenant défini uniquement par les espaceurs. Les espaceurs ont par exemple une largeur d. Entre deux lignes séparées par une distance 3d, l'espace libre devient donc d et cet espace servira à définir les lignes intermédiaires du motif final qui ne sont pas présentes dans le premier motif partiel. On considère ici que le deuxième motif partiel est un motif M2 comprenant notamment quatre lignes d'espaceurs adjacents L1, L2, L3, L4, les lignes L1 et L4 étant considérées comme des lignes extérieures du motif M2 et les lignes adjacentes L2, L3 comme des lignes centrales de ce motif.

La figure 2C représente un troisième motif partiel servant à définir (dans cet exemple) les interruptions des lignes horizontales du motif de la figure 1, et aussi d'autres parties du motif final telles que la limite périphérique du motif final. Le troisième motif partiel est obtenu par la gravure d'une couche complémentaire déposée après la formation des lignes d'espaceurs L1 à L4. Il est défini par lithographie directe (c'est-à-dire sans multiplication de pas) sur cette couche complémentaire, donc avec la résolution que permet la lithographie directe..

On ne s'intéresse ici qu'à la partie centrale M3 du troisième motif partiel, à savoir celle qui a une très petite dimension et qui sert dans cet exemple à définir l'interruption dans l'une des lignes Lh du motif final de la figure 1. La partie centrale M3 a une largeur d'.

Le motif final souhaité est alors défini à ce stade, comme on le voit sur la figure 3, par la combinaison des motifs de la figure 2B et de la figure 2C, c'est-à-dire, dans cet exemple, par l'ensemble des régions libres qui ne sont recouvertes ni par le motif M3 de couche complémentaire ni par le motif d'espaceurs. Ce motif final est bien celui qu'on voulait réaliser (figure 1) ou le complément de celui qu'on voulait réaliser. Il a des lignes horizontales Lh et verticales Lv d'espacement et de largeur d, et une interruption sur une des lignes sur une distance d'. Il est donc le résultat de la combinaison du deuxième motif partiel qui se déduit du premier, et du troisième qui est indépendant du premier et du deuxième mais qui doit être aligné par rapport aux deux autres.

Comme on le voit sur la figure 3, le motif M3 est ici un motif de couche complémentaire qui subsiste entre deux lignes adjacentes d'espaceurs (L2 et L3, lignes centrales du motif M2), mais qui ne s'étend pas, dans la direction perpendiculaire aux lignes L1 à L4, jusque dans les espaces séparant les lignes centrales des lignes extérieures. Le motif M3 a une largeur d' (permise par la lithographie qui définit la couche servant à établir ce motif) dans la direction des lignes. Dans l'autre direction, transversale aux lignes, le motif M3 s'arrête sur les lignes centrales ; il peut avoir une largeur supérieure à d mais elle reste inférieure à la somme de la largeur d et de la largeur des espaceurs. Le motif final est la combinaison du motif de lignes d'espaceurs et d'un motif de couche complémentaire.

Le principe serait le même si le motif M3 était un motif d'absence de couche complémentaire et non un motif de présence de couche : dans le sens des lignes d'espaceurs, la largeur de l'ouverture constituant le motif M3 serait encore d', permise par la lithographie. Dans le sens transversal, l'ouverture M3 dans la couche complémentaire s'arrêterait sur les espaceurs des lignes adjacentes L2 et L3 mais elle ne s'étendrait pas au-dessus des espaces séparant les lignes centrales L2 et L3 des lignes extérieures L1 et L4. Dans ce cas, le motif final est la combinaison d'un motif de lignes d'espaceurs et d'une ouverture dans la couche complémentaire.

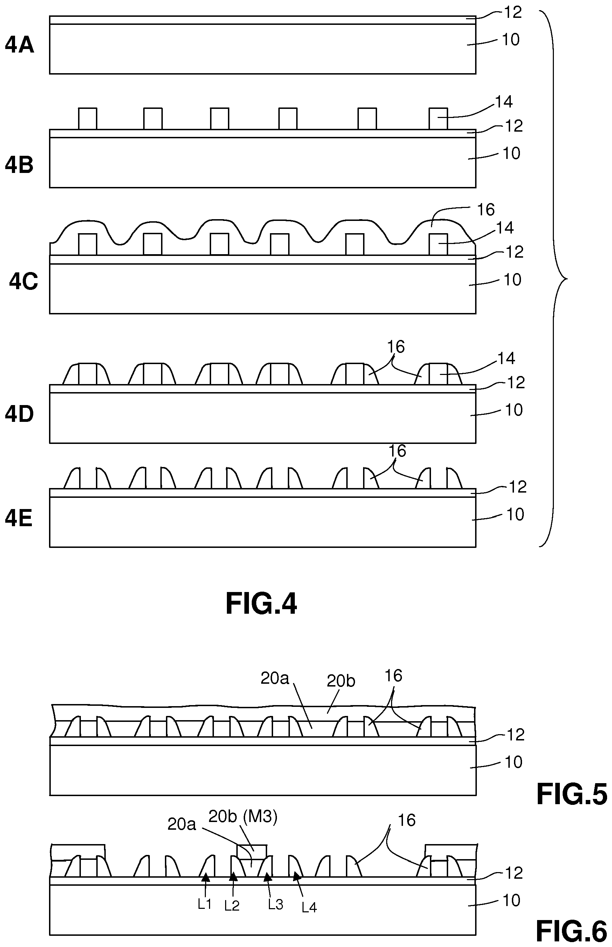

Une réalisation technologique pratique est donnée à titre d'exemple simplifié, en relation avec la figure 4 qui montre les étapes de réalisation à partir d'un simple substrat 10, en matériau isolant (au moins dans sa partie supérieure) recouvert d'une couche superficielle de nitrure de titane 12 (figure 4A) ; le nitrure de titane servira, dans cet exemple, de masque minéral ou masque dur pour la gravure du substrat en matériau isolant ; le premier motif partiel de la figure 2A est défini dans une couche sacrificielle 14 qui peut être par exemple en carbone ; cette couche sacrificielle est déposée sur le substrat et photolithographiée en ultraviolet à 193 nanomètres (figure 4B) ; c'est une couche sacrificielle en ce sens qu'elle sera complètement enlevée ultérieurement ; les espaceurs 16 sont constitués par exemple à partir d'oxyde de silicium déposé de manière conforme sur le substrat recouvert du premier motif de couche sacrificielle (figure 4C) ; l'oxyde de silicium est attaqué uniformément de manière anisotrope verticale jusqu'à mettre à nu la surface supérieure de la couche sacrificielle (figure 4D), mettant à nu en même temps la couche de nitrure, sauf le long des bords des éléments du motif en raison de l'accumulation plus importante d'oxyde le long des bords. Après cette attaque, les tronçons de lignes de couche sacrificielle restent entourés par des espaceurs en oxyde de silicium qui définiront le deuxième motif partiel de la figure 2B ; on élimine alors complètement la couche sacrificielle en laissant subsister les espaceurs (figure 4E).

Le troisième motif partiel, représenté à la figure 2C, peut être constitué de deux manières possibles :
- à partir d'une combinaison d'une couche sensible à un rayonnement photonique ou ionique ou électronique superposée à une couche non sensible en matériau différent de celui des espaceurs, cette couche non sensible ayant une épaisseur inférieure ou à la limite égale à la hauteur des espaceurs, c'est-à-dire sans débordement au-dessus des espaceurs ;
- ou à partir d'une couche unique sensible à un tel rayonnement déposée entre les espaceurs avec une épaisseur inférieure ou égale à la hauteur des espaceurs .

Dans le premier cas (figures 5 et 6), on dépose d'abord une couche 20a en matériau différent de celui des espaceurs et pouvant être gravée par des produits qui n'attaquent pas les espaceurs ; puis on dépose une couche sensible, par exemple une résine photosensible 20b au-dessus de l'ensemble. Pour déposer la couche 20a sans débordement au-dessus des espaceurs, on peut faire un étalement centrifuge sur une épaisseur supérieure à la hauteur des espaceurs, suivi d'une gravure uniforme (gravure en pleine plaque, c'est-à-dire sans masque) sur tout le substrat au moins jusqu'à faire apparaître la surface supérieure des espaceurs.

Après exposition de la résine 20b à un faisceau ultraviolet à 193 nanomètres et après développement (figure 6), on grave la couche 20a ; les portions de couche 20a qui subsistent définissent le troisième motif partiel M3 de faible dimension s'arrêtant sur les bords de deux lignes d'espaceurs adjacents ; elles masquent les zones dans lesquelles se situent les interruptions de lignes à réaliser dans le motif final de la figure 1 ; on aboutit ainsi au motif final désiré, ce motif étant la combinaison des zones qui ne sont recouvertes ni d'espaceurs ni de la couche 20a. Ce motif peut servir à graver la couche de nitrure de titane 12.

On procéderait de la même manière si le motif M3 de faible dimension, s'arrêtant sur les bords de deux lignes d'espaceurs adjacents, était une ouverture dans la couche complémentaire 20a plutôt qu'une portion de couche complémentaire ; le motif final est dans ce cas la combinaison du motif de lignes d'espaceurs et de l'ouverture dans la couche complémentaire.

Avantageusement, pour relâcher les contraintes sur le choix des matériaux, on préférera utiliser pour la couche 20b une résine sensible à un faisceau électronique.

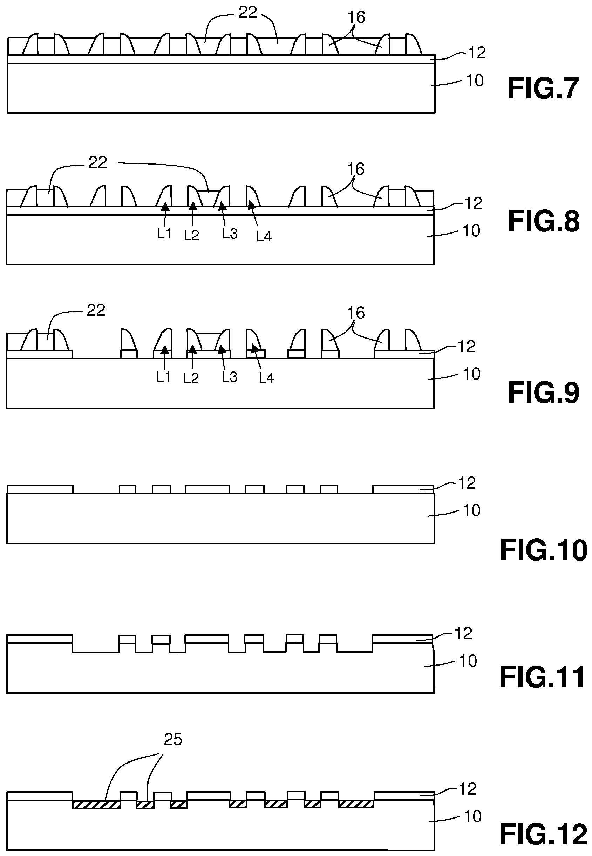

Dans le deuxième cas (figure 7), on dépose uniquement une couche 22 sensible à un rayonnement en lui donnant une épaisseur inférieure ou égale à la hauteur des espaceurs. Pour cela, on fait par exemple un étalement centrifuge sur une épaisseur supérieure à la hauteur des espaceurs, suivi par exemple d'une gravure uniforme (gravure en pleine plaque, c'est-à-dire sans masque) sur tout le substrat au moins jusqu'à faire apparaître la surface supérieure des espaceurs. En variante, il est possible également d'effectuer un dépôt planarisant assez fin de résine suivi d'une étape de recuit entraînant la rétractation de la résine entre les espaceurs.

Après exposition de la couche sensible par le faisceau électronique et après développement, les parties de couche sensible qui subsistent masquent les zones voulues et définissent le troisième motif partiel ou son complément (figure 8). L'ensemble de la couche sensible et des espaceurs définit le motif dense qu'on veut réaliser, qui peut être celui de la figure 3.

Là encore, avantageusement, on utilisera comme couche sensible 22 une couche sensible à un faisceau électronique.

Dans le cas de résines sensibles à un rayonnement photonique, pour photolithographier la couche située entre les espaceurs (dont une dimension est inférieure à la longueur d'onde), on choisira de préférence pour les espaceurs et la couche située entre les espaceurs des matériaux d'indices sensiblement égaux (typiquement avec un écart de moins de 1%).

Si les résines utilisées sont des résines à amplification chimique, les mécanismes de diffusion mis en jeu lors du procédé permettent de lisser les profils et rendre les structures perpendiculaires aux lignes. Pour d'autres types de résine, un traitement thermique de recuit, après l'exposition et le développement de la couche de résine, pourra être utile pour faire fluer les profils de la résine le long des espaceurs et permettre d'obtenir le même résultat.

Les espaceurs de cet exemple sont en oxyde de silicium, mais ils pourraient être en nitrure de silicium. Dans le cas d'une lithographie avec particules (ions ou électrons), ils pourraient aussi, avantageusement, être réalisés en d'autres matériaux de numéro atomique plus élevé, tel que du nitrure de titane ; un matériau de numéro atomique plus élevé permet de mieux confiner dans la zone d'exposition les électrons lors de la gravure par le faisceau électronique ou le faisceau d'ions.

Le motif combiné de couche sensible et d'espaceurs est utilisé pour protéger localement ou au contraire découvrir la couche 12 de nitrure de titane dans une zone de très petite dimension délimitée transversalement par deux lignes adjacentes d'espaceurs . On procède alors à une attaque du nitrure là où il n'est pas protégé, pour réaliser le masque minéral (figure 9). On enlève ensuite la couche sensible et les espaceurs par une gravure pleine plaque (figure 10).

La figure 11 et la figure 12 représentent une utilisation possible du procédé selon l'invention pour la réalisation d'un réseau de lignes conductrices dans un substrat isolant : après la gravure de la couche de nitrure de titane 12 (figure 10) on grave le matériau isolant du substrat là où il n'est pas protégé par le nitrure (figure 11) ; puis on dépose, par un procédé de type damascène un métal conducteur 25 tel que du cuivre dans les emplacements gravés (figure 12). Le métal déposé affleure à la surface du substrat creusé, sans déborder des ouvertures creusées. Si le substrat n'est pas suffisamment isolant, on peut effectuer une isolation du fond et des flancs des ouvertures creusées dans le substrat avant de déposer le métal 25.

L'invention est applicable dans des structures et procédés plus complexes l'exemple précédent. Par exemple, on peut appliquer l'invention pour la réalisation d'une structure dite « double damascène » comprenant un premier réseau de conducteurs enterrés dans un substrat isolant et un deuxième réseau de conducteurs superposé au premier et connecté à ce dernier à travers des vias conducteurs ouverts dans le substrat, les deux réseaux étant dessinés selon des motifs denses.

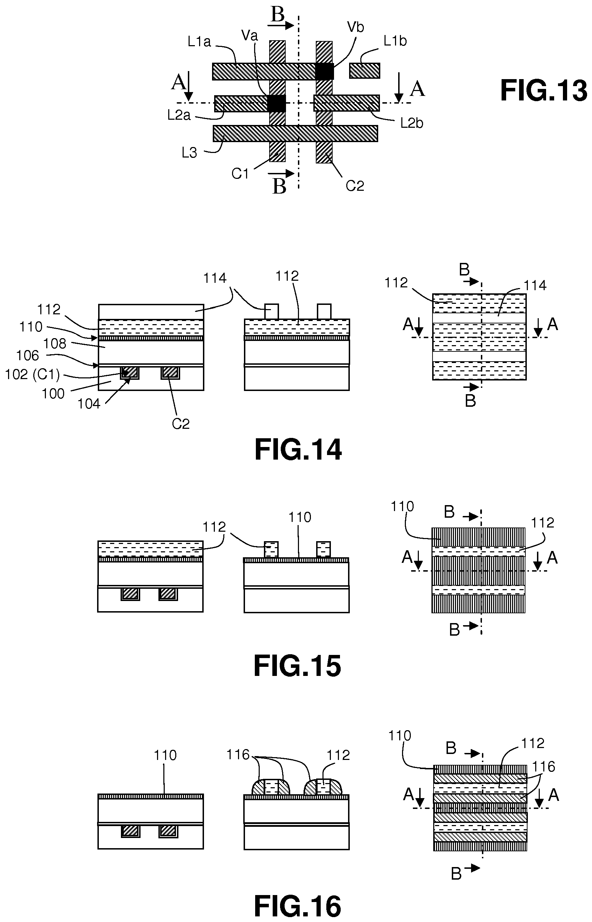

La figure 13 représente en vue de dessus la structure qu'on veut réaliser ; un réseau inférieur comprend des conducteurs en bandes verticales ; un réseau supérieur comprend des conducteurs en bandes horizontales ; deux vias de contact sont représentés à l'endroit des croisements entre un conducteur vertical et un conducteur horizontal ; les autres croisements sont des croisements sans contact.

Le premier réseau (inférieur) comporte dans cet exemple deux conducteurs C1 et C2 orientés verticalement sur le dessin ; le deuxième réseau, supérieur, comporte trois lignes parallèles de conducteurs orientés horizontalement sur le dessin ; deux des lignes sont interrompues à un endroit, c'est-à-dire divisées chacune en deux tronçons séparés par un intervalle ; les tronçons sont L1a, L1b pour la première ligne, L2a, L2b pour la deuxième ligne. La troisième ligne L3 est continue. Les conducteurs horizontaux et verticaux se croisent et deux vias de connexion électrique Va et Vb sont prévus, respectivement au croisement du tronçon L1a et du conducteur C2, et au croisement du tronçon L2a et du conducteur C1. Les autres croisements sont des croisements sans vias de connexion. Les espacements entre conducteurs ou entre tronçons peuvent être aussi petits que 20 à 30 nanomètres.

Le premier réseau de conducteurs peut avoir été fait par n'importe quel procédé et on va décrire essentiellement la fabrication du deuxième réseau et des vias de connexion. Cette fabrication est décrite en référence aux figures 2 à 15 qui illustrent les différentes étapes du procédé. Sur chaque figure on a représenté trois éléments de dessin qui sont respectivement : à droite une vue de dessus de la structure, à gauche une coupe de la structure selon la ligne AA de la vue de dessus, et au centre une coupe selon la ligne BB de la vue de dessus. Pour une meilleure lisibilité des figures, on n'a représenté sur les dessins en coupe que les éléments situés dans le plan de coupe, et on n'a pas représenté sur les vues de dessus les conducteurs enterrés du premier réseau (qui sont visibles sur la figure 13).

On considère donc (figure 14) qu'on part d'un substrat 100 en silicium par exemple dans lequel ont été formés des conducteurs enterrés 102, par exemple des conducteurs de cuivre noyés dans des tranchées dont les flancs sont isolés par du nitrure de tantale 104. Ces conducteurs forment le premier réseau. Le substrat et ses conducteurs enterrés sont recouverts d'une couche isolante ou couche diélectrique 108 qui assure l'isolation entre les deux réseaux de conducteurs ; une couche d'adaptation isolante 106 peut être prévue entre le substrat 100 et la couche diélectrique 108. On formera à travers la couche diélectrique 108 (et la couche 106) des vias aux endroits où un conducteur du deuxième réseau croise un conducteur du premier réseau et doit être relié à ce dernier. La couche diélectrique est de préférence une couche à faible constante diélectrique (low-k dielectric en anglais), telle que de l'oxyde de silicium dopé au carbone ou au fluor.

La couche diélectrique est recouverte d'une couche superficielle 110 formant masque de gravure pour le deuxième réseau de conducteurs et pour les vias conducteurs. Le masque de gravure peut être en nitrure de titane.

Une couche sacrificielle 112, qui peut être en carbone déposé à la tournette (spin-on carbon), recouvre la couche de nitrure 110. Elle sera ultérieurement enlevée.

Une couche de résine 114 sensible aux ultraviolets est déposée et est gravée par photolithographie ultraviolette pour définir un premier motif de résine ; ce motif est un premier motif partiel servant à la définition du deuxième réseau de conducteurs. La résine une fois développée définit les emplacements de protection de la couche sacrificielle. Une couche intermédiaire antireflets, non représentée, facilitant la photolithographie peut être interposée entre la couche sacrificielle 112 et la couche de résine 114.

La couche sacrificielle est attaquée là où elle n'est pas protégée par la résine, et la résine est enlevée (figure 15) ; on aboutit à une structure comprenant le premier motif partiel de régions libres non recouvertes par des éléments de la couche sacrificielle 112.

On forme alors les espaceurs 116 le long des bords des tronçons de la couche sacrificielle (figure 16). Les espaceurs peuvent être en oxyde de silicium ou nitrure de silicium ou un oxynitrure de silicium SiOxNy, ou encore un matériau organique. Les espaceurs peuvent être formés par un dépôt conforme d'une couche, suivie d'une gravure anisotrope verticale sur une épaisseur limitée, mettant à nu la surface supérieure de la couche sacrificielle et mettant à nu en même temps la couche 110, mais laissant subsister des portions le long de tous les flancs des éléments de la couche sacrificielle. Ces portions subsistent du fait de la surépaisseur de couche qui s'accumule le long de ces flancs lors du dépôt conforme ; elles constituent les espaceurs 116.

Les zones non recouvertes par les espaceurs et la couche sacrificielle définissent un deuxième motif partiel, déduit directement du premier puisqu'il n'y a pas eu d'autre opération de photolithographie après la définition du premier motif partiel.

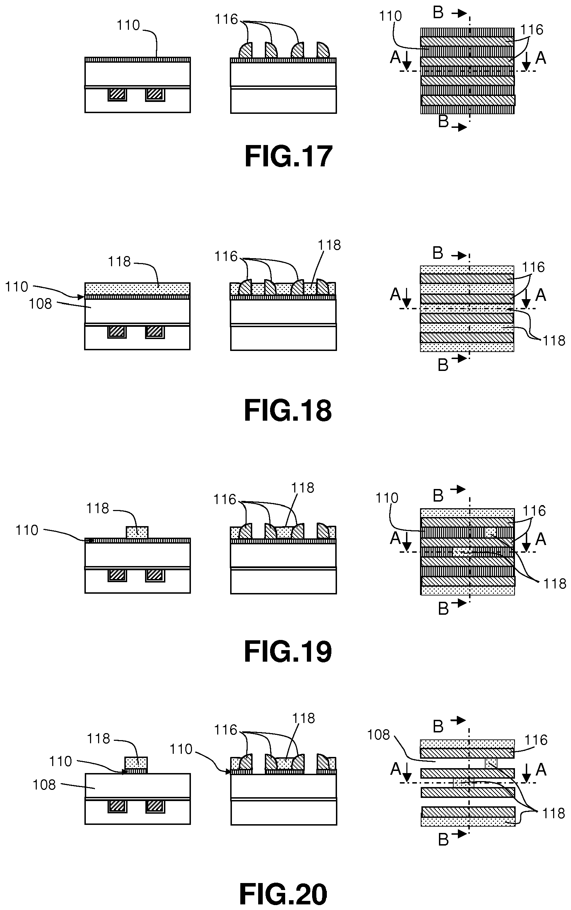

A ce stade, on élimine la couche sacrificielle 112, ne laissant subsister que les espaceurs 116 (figure 17). Le motif de régions libres est alors une combinaison des premier et deuxième motifs partiels.

On dépose alors (figure 18) une couche 118 sensible à un faisceau d'électrons, sur une épaisseur inférieure à la hauteur des espaceurs (qui est elle-même la hauteur de la couche sacrificielle qui a maintenant disparu). S'il est nécessaire de faire une gravure pleine plaque de la couche sensible118 pour en réduire la hauteur jusqu'à ce qu'elle ne dépasse plus des espaceurs, on fait cette gravure à ce stade.

On effectue ensuite la gravure par faisceau d'électrons. La couche sensible développée définit un troisième motif partiel (figure 19). Ici, le troisième motif partiel est un motif de couche subsistant après gravure. Cette opération de lithographie est utilisée pour compléter la définition du motif de conducteurs du deuxième réseau, et plus précisément ici la définition des interruptions entre les tronçons de lignes, L1a, L1b par exemple : les interruptions sont masquées par la couche sensible 118. Le troisième motif partiel recouvre une zone séparant deux lignes adjacentes d'espaceurs mais s'arrête sur ces lignes sans déborder de l'autre côté.

Après cette opération, il subsiste sur le substrat un motif final de régions libres qui ne sont masquées ni par les espaceurs ni par la couche sensible 118 ; ce motif est une combinaison des premier, deuxième et troisième motifs partiels. Il constitue le motif de conducteurs du deuxième réseau, incluant les emplacements de vias conducteurs.

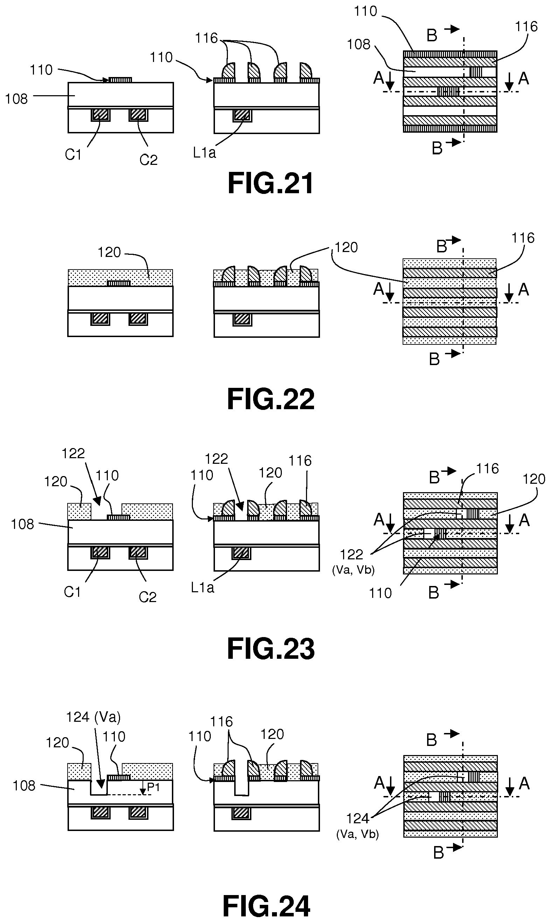

On attaque alors la couche de masque de gravure 110 là où elle n'est recouverte ni par la couche sensible ni par les espaceurs, pour y reporter le motif final (figure 20) ; le masque correspond alors au motif de conducteurs du deuxième réseau, avec ses interruptions dans les lignes L1a et L2a de la figure 13. Enfin, on enlève la couche sensible 118 (figure 21).

On fera attention que sur les figures 21 à 27 la ligne de coupe verticale B-B n'est pas située au même endroit que sur les figures précédentes : elle passe maintenant à travers le via Va situé en haut à droite sur la figure 13 (les vias ne sont pas encore définis à ce stade).

Pour définir les vias, on va utiliser une nouvelle couche sensible à un faisceau d'électrons, et là encore, l'épaisseur de cette couche est plus faible que la hauteur des espaceurs 116.

Il est possible de déposer cette couche sensible soit maintenant soit après avoir préalablement gravé le substrat sur une partie de sa profondeur. On va d'abord décrire en détail le cas où on dépose immédiatement la nouvelle couche sensible, et on décrira ensuite la possibilité de ne la déposer qu'ultérieurement.

On dépose donc une nouvelle couche sensible 120 (figure 22) sur une épaisseur inférieure à la hauteur des espaceurs.

On ouvre dans la couche sensible des ouvertures 122 selon un motif qui sert à délimiter les vias conducteurs à réaliser (figure 23) ; les ouvertures 122 sont formées à l'emplacement de croisements de conducteurs des deux réseaux, là où des contacts doivent être établis entre deux conducteurs qui se croisent. La gravure de la couche sensible est faite par un faisceau d'électrons. Sa résolution est améliorée du fait de la hauteur de couche sensible inférieure à la hauteur des espaceurs, et ceci encore mieux dans le cas où les espaceurs sont en matériaux relativement lourds susceptibles de mieux absorber les électrons dispersés latéralement lors de l'exposition au faisceau électronique.

Le motif de gravure des ouvertures 122 de la couche sensible peut déborder en partie sur des zones du masque de gravure 110 (voir sur la partie gauche de la figure 23) ; dans ce cas c'est le masque de gravure qui définira le bord des vias ; à d'autres endroits (voir encore la partie gauche de la figure 23), le bord de la couche sensible repose directement sur la couche diélectrique 108 et dans ce cas c'est la couche sensible qui définit le bord du via ; enfin, à d'autres endroits encore et sur au moins deux bords des vias, le bord de la couche sensible s'arrête sur des espaceurs de lignes adjacentes et dans ce cas ce sont les espaceurs qui définissent les bords des vias (voir la partie centrale de la figure 23 le via au-dessus d'un conducteur du premier réseau). L'ouverture définie dans la couche sensible s'étend dans ce cas sur une zone qui, dans le sens transversal aux lignes d'espaceurs, ne surplombe que l'espace entre deux lignes d'espaceurs adjacentes mais ne déborde pas au-delà de ces lignes d'espaceurs.

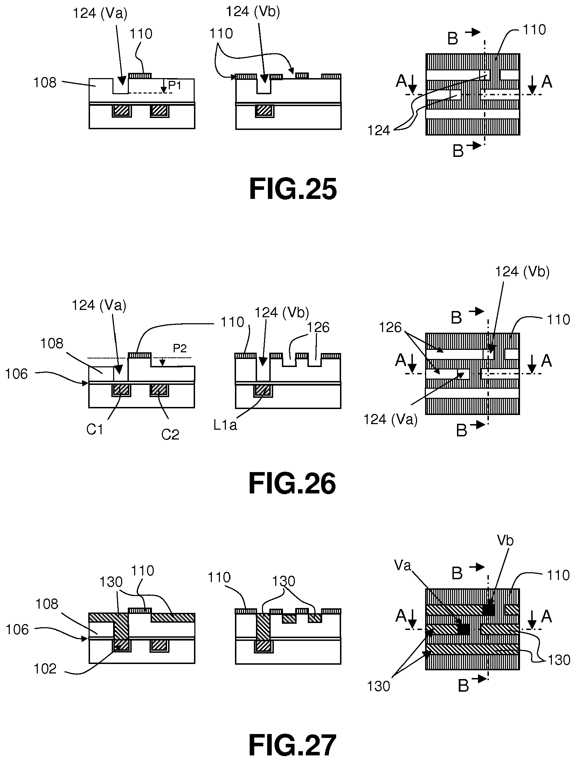

On grave alors des vias 124 dans la couche diélectrique 108 sur une première profondeur P1, inférieure à l'épaisseur de la couche 108, aux emplacements où la couche diélectrique n'est protégée ni par le masque de nitrure 110 ni par la couche sensible 120 (figure 24). Puis on enlève la couche sensible et les espaceurs (figure 25).

On continue la gravure de la couche diélectrique sur une deuxième profondeur P2 (figure 26) ; la gravure est définie cette fois par le seul masque de nitrure 110 qui correspond exactement au motif de conducteurs du deuxième réseau ; la profondeur P2 correspond à l'épaisseur souhaitée pour les conducteurs du deuxième réseau ; là où il y a les vias 124, la gravure cumule les deux profondeurs P1 et P2 et la somme des profondeurs est telle que les vias atteignent le premier réseau de conducteurs ; la profondeur P1 est donc le complément de profondeur de gravure nécessaire pour atteindre les conducteurs du premier réseau.

Si une couche d'adaptation 106 est prévue dans la structure, elle est éliminée dans le fond des vias à ce stade pour dénuder les conducteurs du premier réseau au fond des vias. On dépose alors du métal conducteur 130 dans les ouvertures gravées dans la couche 108, y compris au fond des vias. Ce métal forme le deuxième réseau conducteur ainsi que les vias entre les deux réseaux (figure 27).

Le métal conducteur peut être du cuivre, qui est ultérieurement arasé pour ne pas déborder de ces emplacements creusés. Le dépôt de cuivre selon ce procédé damascène peut comprendre des étapes telles qu'un dépôt préalable de nitrure de tantale au fond des ouvertures gravées dans la couche 108. Ces étapes ne sont pas détaillées.

Le masque de nitrure est enlevé en fin de traitement.

La structure de double réseau de conducteurs à ce stade est bien celle que l'on voulait et qui est représentée à la figure 13.

Comme on l'a dit ci-dessus, on peut inverser l'ordre des gravures de la couche diélectrique 108 et effectuer la première étape de gravure avant de déposer la nouvelle couche 120 sensible au faisceau électronique. Cela revient globalement à exécuter l'étape de la figure 26 avant les étapes des figures 22 à 24. On inverse donc l'ordre de creusement des profondeurs P1 et P2 : P2 devient la première profondeur creusée pour réaliser les conducteurs, P1 devient la deuxième profondeur creusée pour réaliser les vias.

Par conséquent, après la gravure du masque minéral 110 (figure 20), on creuse le matériau isolant du substrat dans les régions qui ne sont pas recouvertes par le masque minéral, sur une première profondeur (qu'on appeler P2 : c'est la profondeur nécessaire pour réaliser les conducteurs du deuxième réseau) ; puis on dépose la nouvelle couche 120 sensible à un faisceau électronique sur une épaisseur inférieure ou égale à la hauteur des espaceurs, on grave cette couche sensible au moyen d'un faisceau électronique, on creuse le matériau isolant du substrat sur une deuxième profondeur (qu'on peut appeler P1) là où il n'est pas recouvert par la couche sensible ou le masque, on élimine la couche sensible et les espaceurs, et enfin on remplit avec un métal conducteur les emplacements creusés dans le matériau isolant.

La somme des profondeurs P1+P2 est la profondeur du premier réseau de conducteurs.

Les emplacements gravés dans le matériau isolant du substrat sont remplis de métal conducteur, et parmi ces emplacements, ceux qui sont creusés sur la première profondeur uniquement (P2) constituent un deuxième réseau de conducteurs, et ceux qui sont creusés sur la somme de la première (P2) et la deuxième profondeur (P1) constituent des vias de connexion entre le premier réseau et le deuxième réseau.

## Revendications

1. Procédé de lithographie pour graver un motif de densité élevée à partir d'une combinaison de plusieurs motifs partiels moins denses, le procédé comprenant la formation d'une couche sacrificielle (14) sur un substrat (10) et une gravure de la couche sacrificielle selon un premier motif partiel comprenant des lignes parallèles, puis la formation d'espaceurs (16) sur les bords des éléments de la couche sacrificielle ainsi gravée, puis l'enlèvement de la couche sacrificielle pour ne laisser subsister que les espaceurs, ceux-ci définissant un deuxième motif partiel d'au moins quatre lignes parallèles comprenant deux lignes centrales adjacentes et deux lignes extérieures, **caractérisé en ce qu'**on effectue ensuite le dépôt d'une couche complémentaire (22) d'un matériau différent de celui des espaceurs entre les espaceurs sur une épaisseur inférieure ou égale à la hauteur des espaceurs, et on grave localement cette couche complémentaire selon un troisième motif partiel pour définir sur le substrat un motif final résultant de la combinaison des deuxième et troisième motifs partiels , et **caractérisé en ce que** le troisième motif partiel comprend au moins une zone qui s'étend dans une direction perpendiculaire aux lignes d'espaceurs, entre les deux lignes centrales adjacentes, et qui s'arrête de chaque côté sur ces lignes d'espaceurs adjacents sans déborder dans cette direction au-delà des lignes centrales adjacentes.

2. Procédé selon la revendication 1, **caractérisé en ce que** la couche complémentaire de matériau différent de celui des espaceurs est une couche d'un matériau sensible à un rayonnement photonique ou électronique ou ionique et le retrait se fait par exposition à un tel rayonnement.

3. Procédé selon la revendication 2, **caractérisé en ce qu'**il comprend, après le retrait local, une étape supplémentaire de traitement thermique apte à faire fluer les profils de la couche sensible le long des espaceurs.

4. Procédé selon la revendication 2, **caractérisé en ce que** la couche de matériau sensible est sensible à un rayonnement photonique et le matériau de cette couche a sensiblement le même indice de réfraction que le matériau formant les espaceurs.

5. Procédé selon l'une des revendications 1 à 4, **caractérisé en ce que** le substrat comporte une couche superficielle (12, 110)) constituant un masque minéral pour la gravure du substrat sous cette couche, et **en ce que** le motif final de régions dépourvues d'espaceurs et de couche complémentaire sert à graver le masque minéral préalablement à la gravure du substrat.

6. Procédé de lithographie selon la revendication 5, **caractérisé en ce qu'**on creuse le substrat (10) à travers le masque minéral.

7. Procédé selon la revendication 6, **caractérisé en ce que** les régions creusées dans le substrat sont remplies par un matériau (25) affleurant à la surface du substrat sans déborder des régions creusées.

8. Procédé selon la revendication 7, **caractérisé en ce que** le substrat est en matériau isolant et les régions creusées dans le substrat sont remplies d'un matériau électriquement conducteur pour former un réseau dense de conducteurs.

9. Procédé selon la revendication 5, **caractérisé en ce que**, après la gravure du masque minéral, on dépose une nouvelle couche (120) sur une épaisseur inférieure ou égale à la hauteur des espaceurs, on retire localement cette couche, et on creuse le matériau isolant du substrat sur une première profondeur (P1) dans l'espace qui n'est recouvert ni par la nouvelle couche (120) ni par les espaceurs (116).

10. Procédé selon la revendication 9, **caractérisé en ce qu'**après le creusement sur la première profondeur, on élimine la nouvelle couche (120) et on creuse le matériau isolant du substrat sur une deuxième profondeur (P2).

11. Procédé selon la revendication 10, **caractérisé en ce que** le substrat comporte un premier réseau de conducteurs enterrés (102) à une profondeur égale à la somme de la première et de la deuxième profondeur, les emplacements gravés dans le matériau isolant du substrat sur la somme de ces deux profondeurs constituant des vias d'accès (124) aux conducteurs enterrés, les emplacements gravés dans le matériau isolant du substrat sont remplis de métal conducteur (130), et parmi ces emplacements, ceux qui sont creusés sur la deuxième profondeur uniquement (P2) constituent un deuxième réseau de conducteurs reliés par les vias au premier réseau.

12. Procédé selon la revendication 5, **caractérisé en ce que**, après la gravure du masque minéral (110), on creuse le matériau isolant (108) du substrat là où il n'est pas protégé par le masque, sur une première profondeur, puis on dépose une nouvelle couche sensible à un faisceau électronique sur une épaisseur inférieure ou égale à la hauteur des espaceurs, on grave cette couche sensible au moyen d'un faisceau électronique, on creuse le matériau isolant du substrat sur une deuxième profondeur dans l'espace qui n'est pas recouvert par la couche sensible, on élimine la couche sensible et les espaceurs, et enfin on remplit avec un métal conducteur les emplacements creusés dans le matériau isolant.

13. Procédé selon la revendication 12, **caractérisé en ce que** le substrat comporte un premier réseau de conducteurs enterrés à une profondeur égale à la somme de la première et de la deuxième profondeur, les emplacements gravés dans le matériau isolant du substrat sont remplis de métal conducteur, et parmi ces emplacements, ceux qui sont creusés sur la première profondeur uniquement constituent un deuxième réseau de conducteurs, et ceux qui sont creusés sur la somme de la première et la deuxième profondeur constituent des vias de connexion entre le premier réseau et le deuxième réseau.

## Patentansprüche

1. Lithografisches Verfahren zum Gravieren eines Motivs hoher Dichte anhand einer Kombination mehrerer weniger dichter Teilmotive, wobei das Verfahren das Bilden einer Opferschicht (14) auf einem Substrat (10) und eine Gravur der Opferschicht entsprechend eines ersten Teilmotivs beinhaltet, welches parallele Linien beinhaltet, gefolgt von Bilden von Abstandselementen (16) an den Rändern der Elemente der so gravierten Opferschicht, gefolgt von Entfernen der Opferschicht, um nur die Abstandselemente zu belassen, wobei diese ein zweites Teilmotiv von mindestens vier parallelen Linien definieren, welche zwei mittlere, aneinandergrenzende Linien und zwei äußere Linien beinhalten, **dadurch gekennzeichnet, dass** man anschließend die Ablagerung einer Zusatzschicht (22) aus einem Material vornimmt, welches sich von demjenigen der Abstandselemente unterscheidet, zwischen den Abstandselementen, über eine Dicke, die kleiner oder gleich der Höhe der Abstandselemente ist, und man lokal diese Zusatzschicht entsprechend eines dritten Teilmotivs graviert, um auf dem Substrat ein Endmotiv zu definieren, welches aus der Kombination des zweiten und des dritten Teilmotivs resultiert, und **dadurch gekennzeichnet, dass** das dritte Teilmotiv mindestens einen Bereich beinhaltet, der sich in eine Richtung rechtwinklig zu den Linien der Abstandselemente, zwischen den beiden aneinandergrenzenden mittleren Linien erstreckt, und der beiderseits an diesen aneinandergrenzenden Abstandselement-Linien endet, ohne in diese Richtung die aneinandergrenzenden mittleren Linien zu übertreten.

2. Verfahren nach Anspruch 1, **dadurch gekennzeichnet, dass** die zusätzliche Schicht aus Material, welches sich von demjenigen der Abstandselemente unterscheidet, eine Schicht aus einem Material ist, welches empfindlich für eine Photonen- oder Elektronen- oder Ionenstrahlung ist, und das Entfernen durch Exposition gegenüber einer solchen Strahlung erfolgt.

3. Verfahren nach Anspruch 2, **dadurch gekennzeichnet, dass** es, nach dem lokalen Entfernen, einen zusätzlichen Schritt der Wärmebehandlung beinhaltet, welcher in der Lage ist, die Profile der empfindlichen Schicht entlang der Abstandselemente zum Kriechen zu veranlassen.

4. Verfahren nach Anspruch 2, **dadurch gekennzeichnet, dass** die Schicht aus empfindlichem Material empfindlich gegenüber einer Photonenstrahlung ist und das Material dieser Schicht im Wesentlichen den gleichen Brechungsindex besitzt wie dasjenige Material, welches die Abstandselemente bildet.

5. Verfahren nach einem der Ansprüche 1 bis 4, **dadurch gekennzeichnet, dass** das Substrat eine Oberflächenschicht (12, 110) beinhaltet, welche eine mineralische Maske für die Gravur des Substrates unterhalb dieser Schicht bildet, und dadurch, dass das Endmotiv von Bereichen ohne Abstandselemente und ohne zusätzliche Schicht dazu dient, die mineralische Maske vor dem Gravieren des Substrates zu gravieren.

6. Lithografisches Verfahren nach Anspruch 5, **dadurch gekennzeichnet, dass** das Substrat (10) durch die mineralische Maske hindurch gehöhlt wird.

7. Verfahren nach Anspruch 6, **dadurch gekennzeichnet, dass** die in das Substrat gehöhlten Bereiche durch ein Material (25) gefüllt werden, welches an der Oberfläche des Substrates bündig anliegt, ohne aus den gehöhlten Bereichen überzutreten.

8. Verfahren nach Anspruch 7, **dadurch gekennzeichnet, dass** das Substrat aus einem isolierenden Material besteht und die in das Substrat gehöhlten Bereiche mit einem elektrisch leitenden Material gefüllt sind, um ein dichtes Leiternetz zu bilden.

9. Verfahren nach Anspruch 5, **dadurch gekennzeichnet, dass** man, nach dem Gravieren der mineralischen Maske, eine neue Schicht (120) über eine Dicke ablagert, die kleiner oder gleich der Höhe der Abstandselemente ist, man lokal diese Schicht entfernt, und man das isolierende Material des Substrates über eine erste Tiefe (P1) in demjenigen Raum höhlt, der weder von der neuen Schicht (120) noch von den Abstandselementen (116) bedeckt ist.

10. Verfahren nach Anspruch 9, **dadurch gekennzeichnet, dass** man, nach dem Höhlen über die erste Tiefe, die neue Schicht (120) beseitigt und man das isolierende Material des Substrates über eine zweite Tiefe (P2) höhlt.

11. Verfahren nach Anspruch 10, **dadurch gekennzeichnet, dass** das Substrat ein erstes Netz von unterirdischen Leitern (102) in einer Tiefe beinhaltet, welche der Summe der ersten und der zweiten Tiefe entspricht, wobei die im isolierenden Material des Substrates über die Summe dieser beiden Tiefen gravierten Positionen Zugangs-Durchgangsverbindungen (124) zu den unterirdischen Leitern bilden, wobei die in das isolierende Material des Substrates gravierten Positionen mit leitendem Metall (130) gefüllt sind, und unter diesen Positionen, diejenigen, die nur über die zweite Tiefe (P2) gehöhlt sind, ein zweites Netz von Leitern bilden, welche über die Durchgangsverbindungen mit dem ersten Netz verbunden sind.

12. Verfahren nach Anspruch 5, **dadurch gekennzeichnet, dass** man, nach dem Gravieren der mineralischen Maske (110) das isolierende Material (108) des Substrates dort, wo es nicht durch die Maske geschützt ist, über eine erste Tiefe höhlt, und man anschließend eine neue, für einen Elektronenstrahl empfindliche Schicht, über eine Dicke ablagert, welche kleiner oder gleich der Höhe der Abstandselemente ist, man diese empfindliche Schicht mit Hilfe eines Elektronenstrahls graviert, man das isolierende Material des Substrates über eine zweite Tiefe in einem Raum höhlt, der nicht durch die empfindliche Schicht bedeckt ist, man die empfindliche Schicht und die Abstandselemente beseitigt und man abschließend mit einem leitenden Metall die in das isolierende Material gehöhlten Positionen füllt.

13. Verfahren nach Anspruch 12, **dadurch gekennzeichnet, dass** das Substrat ein erstes Netz aus unterirdischen Leitern in einer Tiefe beinhaltet, welche der Summe der ersten und der zweiten Tiefe entspricht, wobei die in das isolierende Material des Substrates gravierten Positionen mit leitendem Metall gefüllt sind, und unter diesen Positionen, diejenigen, die nur über die erste Tiefe gehöhlt sind, ein zweites Netz von Leitern bilden, und diejenigen, welche über die Summe der ersten und der zweiten Tiefe gehöhlt sind, Anschluss-Durchgangsverbindungen zwischen dem ersten Netz und dem zweiten Netz bilden.

## Claims

1. A lithographic method for etching a pattern with high density based on a combination of several less dense partial patterns, the method comprising the formation of a sacrificial layer (14) on a substrate (10) and an etching of the sacrificial layer according to a first partial pattern comprising parallel lines, then the formation of spacers (16) on the edges of the elements of the sacrificial layer thus etched, then the removal of the sacrificial layer to leave only the spacers remaining, the latter defining a second partial pattern of at least four parallel lines comprising two adjacent central lines and two outside lines, **characterized in that** the deposition of a complementary layer (22) of a material different from that of the spacers is subsequently carried out between the spacers to a thickness less than or equal to the height of the spacers, and this complementary layer is locally etched according to a third partial pattern so as to define on the substrate a final pattern resulting from the combination of the second and third partial patterns, and **characterized in that** the third partial pattern comprises at least one region which extends in a direction perpendicular to the lines of spacers, between the two adjacent central lines, and which stops on either side on these lines of adjacent spacers without going in this direction beyond the adjacent central lines.

2. The method as claimed in claim 1, **characterized in that** the complementary layer of material different from that of the spacers is a layer of a material sensitive to photon or electron or ion radiation and the removal is carried out by exposure to such a type of radiation.

3. The method as claimed in claim 2, **characterized in that** it comprises, after the local removal, an additional thermal treatment step capable of making the profiles of the sensitive layer flow along the spacers.

4. The method as claimed in claim 2, **characterized in that** the layer of sensitive material is sensitive to photon radiation and the material of this layer has substantially the same index of refraction as the material forming the spacers.

5. The method as claimed in one of claims 1 to 4, **characterized in that** the substrate comprises a surface layer (12, 110) forming a mineral mask for the etching of the substrate under this layer, and **in that** the final pattern of regions lacking spacers and a complementary layer is used to etch the mineral mask prior to the etching of the substrate.

6. The lithographic method as claimed in claim 5, **characterized in that** the substrate (10) is hollowed through the mineral mask.

7. The method as claimed in claim 6, **characterized in that** the regions hollowed into the substrate are filled with a material (25) flush with the surface of the substrate without overspilling from the hollowed out regions.

8. The method as claimed in claim 7, **characterized in that** the substrate is made from an insulating material and the regions hollowed into the substrate are filled with an electrically conducting material so as to form a dense network of conductors.

9. The method as claimed in claim 5, **characterized in that**, after the etching of the mineral mask, a new layer (120) is deposited over a thickness less than or equal to the height of the spacers, this layer is locally removed, and the insulating material of the substrate is hollowed down to a first depth (P1) in the space which is not covered either by the new layer (120) or by the spacers (116).

10. The method as claimed in claim 9, **characterized in that**, after hollowing down to the first depth, the new layer (120) is eliminated and the insulating material of the substrate is hollowed down to a second depth (P2).

11. The method as claimed in claim 10, **characterized in that** the substrate comprises a first network of conductors (102) buried at a depth equal to the sum of the first and of the second depth, the locations etched into the insulating material of the substrate over the sum of these two depths forming access vias (124) to the buried conductors, the locations etched into the insulating material of the substrate are filled with conducting metal (130), and amongst these locations, those that are only hollowed down to the second depth (P2) form a second network of conductors connected by the vias to the first network.

12. The method as claimed in claim 5, **characterized in that**, after the etching of the mineral mask (110), the insulating material (108) of the substrate is hollowed down to a first depth, at the places where it is not protected by the mask, then a new layer sensitive to an electron beam is deposited to a thickness less than or equal to the height of the spacers, this sensitive layer is etched by means of an electron beam, the insulating material of the substrate is hollowed down to a second depth in the space which is not covered by the sensitive layer, the sensitive layer and the spacers are eliminated, and lastly the locations hollowed into the insulating material are filled with a conducting metal.

13. The method as claimed in claim 12, **characterized in that** the substrate comprises a first network of conductors buried at a depth equal to the sum of the first and of the second depth, the locations etched into the insulating material of the substrate are filled with conducting metal, and amongst these locations, those that are only hollowed down to the first depth form a second network of conductors, and those that are hollowed down to the sum of the first and the second depth form vias for connection between the first network and the second network.
